**Europäisches Patentamt**

**European Patent Office**

**Office européen des brevets**

(11) Veröffentlichungsnummer: **0 333 655**
A2

# (12) EUROPÄISCHE PATENTANMELDUNG

(21) Anmeldenummer: **89810176.1**

(22) Anmeldetag: **08.03.89**

(51) Int. Cl.⁴: **G 03 C 1/68**

(30) Priorität: **17.03.88 DE 3808927**

(43) Veröffentlichungstag der Anmeldung:
**20.09.89 Patentblatt 89/38**

(84) Benannte Vertragsstaaten:
**AT BE CH DE FR GB IT LI NL SE**

(71) Anmelder: **CIBA-GEIGY AG**
**Klybeckstrasse 141**
**CH-4002 Basel (CH)**

(72) Erfinder: **Bartmann, Ekkehard, Dr.**
**Dieburger Weg 12a**
**D-6106 Erzhausen (DE)**

**Klug, Rudolf, Dr.**
**Grüne Waldstrasse 25**
**D-8750 Aschaffenburg (DE)**

**Schulz, Reinhard, Dr.**
**Im Trappengrund 44**
**D-6107 Reinheim (DE)**

**Härtner, Hartmut, Dr.**
**Mathildenweg 9**
**D-6109 Mühltal (DE)**

(54) **Negativ-Fotoresists vom Polyimid-Typ mit 1,2-Disulfonen.**

(57) Die Erfindung betrifft Negativ-Fotoresists vom Polyimid-Typ, enthaltend in einem organischen Lösungsmittel im wesentlichen mindestens je

a) ein in hochwärmebeständiges Polyimid-Polymer überführbares Polyamidsäure- oder Polyamidsäurederivat-Präpolymer

b) einen Fotoinitiator sowie gegebenenfalls weitere übliche Zusatzstoffe, die als Fotoinitiator eine Verbindung der Formel I
$R^1-SO_2-SO_2-R^2$   I
mit den für $R^1$ und $R^2$ angegebenen Bedeutungen enthalten.

## Beschreibung

### Negativ-Fotoresists vom Polyimid-Typ mit 1,2-Disulfonen

Die Erfindung betrifft Negativ-Fotoresists vom Polyimid-Typ mit 1,2-Disulfon-Verbindungen als Fotoinitiatoren.

Die Herstellung von Halbleiterbauelementen und integrierten Schaltungen in der Mikroelektronik erfolgt praktisch ausschließlich unter Anwendung photolithographischer Strukturierungsprozesse. Zur Herstellung von bestimmte Schaltungsstrukturen aufweisenden Mikrochips wird das Halbleitersubstratmaterial, im allgemeinen sind das Siliziumscheiben, mit Fotolack beschichtet und durch bildmäßiges Belichten und anschließendes Entwickeln werden hierauf Fotoresist-Reliefstrukturen erzeugt. Diese dienen als Maske für die eigentlichen Strukturierungsprozesse am Halbleitersubstrat wie Ätzen, Dotieren, Beschichten mit Metallen, anderen Halbleiter- oder auch Isolatormaterialien. Nach diesen Prozessen werden die Fotoresist-Masken je nach Notwendigkeit wieder entfernt. Durch eine Vielzahl derartiger Prozeßzyklen entstehen auf dem Substrat die Schaltungsstrukturen der Mikrochips.

Es werden grundsätzlich zwei verschiedene Typen von Fotoresists unterschieden: Bei positiv arbeitenden Fotoresists werden die belichteten Bereiche durch einen Entwicklungsprozeß abgelöst, während die unbelichteten Bereiche als Schicht auf dem Substrat verbleiben. Bei negativ arbeitenden Fotoresists verbleiben umgekehrt die bestrahlten Schichtbereiche als Reliefstruktur.

Die ständig fortschreitende Miniaturisierung in der Halbleitertechnologie und Mikroelektronik stellt an die Fotoresist-Materialien und die damit darzustellenden Reliefstrukturen höchste Anforderungen, wobei der Empfindlichkeit sowie der Auflösung und dem Kontrast des Fotoresist, der Haftfestigkeit, der mechanischen und chemischen Stabilität, der Dimensionstreue und Beständigkeit bei erhöhten Temperaturen oder anderen Einflüssen, die bei den weiteren Prozeßschritten auf die Fotoresist-Reliefstrukturen einwirken können, besondere Bedeutung zukommen.

Unter Fotoresists vom Polyimid-Typ sind ganz allgemein solche Materialien zu verstehen, deren schichtbildende Hauptkomponenten lösliche und gegebenenfalls photopolymerisierbare Polyimide oder Polyamidsäure- bzw. Polyamidsäurederivat-Präpolymere sind, die sich in Polymere vom Polyimid-Typ überführen lassen.

Polyimid- und Polyimid-verwandte Polymere verfügen naturgemäß über eine besonders ausgeprägte Hitze- und Chemikalienbeständigkeit. Fotoresists vom Polyimid-Typ werden deshalb vornehmlich dort eingesetzt, wo es gerade auf diese besonderen Eigenschaften ankommt. Mit Hilfe derartiger, überwiegend negativ arbeitender Materialien lassen sich hochwärmebeständige Photopolymer-Reliefstrukturen und -Beschichtungen erzeugen. Hauptanwendungsgebiet ist die Herstellung mikroelektronischer und optoelektronischer Schaltungen und Bauelemente. Hierbei können diese Materialien sowohl als temporäre Fotoresistmasken als auch als bleibende Strukturen fungieren, wie beispielsweise als Isolations-, Schutz- oder Passivierungsschichten, dielektrische Schichten oder bei Flüssigkristallanzeigezellen als Orientierungsschichten. Polyimid materialien sind beispielsweise auch sehr gut geeignet zum Schutz von Halbleiterschaltungen vor α-Strahlung.

Die bekannten und in der Praxis auch hauptsächlich eingesetzten Fotoresists vom Polyimid-Typ leiten sich überwiegend von den Grundsystemen ab, wie sie in den Patentschriften DE-PS 23 08 830 und DE-PS 24 37 340 beschrieben sind. Diese enthalten Polyamidsäureester, die ethylenisch ungesättigte strahlungsvernetzbare Gruppen wie vorzugsweise Allyloxy- oder (Meth)Acryloyloxy-Gruppen aufweisen. Weiterentwicklungen hiervon, wie beispielsweise in den Offenlegungsschriften EP-OS 47 184 und DE-OS 35 01 028 beschrieben, enthalten zusätzlich zum Zwecke der Steigerung der Empfindlichkeit strahlungsreaktive copolymerisierbare ungesättigte Verbindungen, Fotosensibilisatoren und Farbstoffe sowie insbesondere effektivere radikalbildende Fotoinitiatoren. In jedem Falle enthalten praktisch alle leistungsfähigen Fotoresist-Systeme vom Polyimid-Typ photopolymerisierbare ungesättigte Komponenten, sei es zumindest im Präpolymer selbst oder nur durch zusätzliche Komponenten wie etwa in EP-OS 65 352 beschrieben.

Die bekannten Systeme sind jedoch noch vielfältig verbesserungswürdig.

Die vielfach hierin als Strahlungsvernetzer eingesetzten Azid-Fotoinitiatoren, beispielsweise jene auch DE-OS 29 19 841, sind aufgrund ihrer Thermolabilität in Herstellung und Umgang problematisch. Sie sind explosionsgefährlich und bedürfen daher entsprechend aufwendiger Sicherheitsmaßnahmen. Weiterhin wurde gefunden, daß die Stabilität von organischen Aziden in N-Methylpyrrolidon, dem überwiegend in Fotoresists vom Polyimid-Typ verwendeten Lösungsmittel, nicht ausreichend ist. So nimmt bei Lagerung der Gehalt an Azid-Fotoinitiator in der Fotoresistlösung merklich ab, was sich dann entsprechend negativ auf die Empfindlichkeit des Fotoresist auswirkt.

Die Bisimidazol-Fotoinitiatoren von EP-OS 47 184 können in verschiedener Hinsicht nicht befriedigen. Zum einen enthalten die bevorzugten Bisimidazole gebundenes Chlor, das in Polymerschichten die permanent in elektronischen Bauteilen verbleiben sollen, unerwünscht ist. Zum anderen können mit den entsprechenden Resistsystemen Reliefstrukturen mit größerer Schichtdicke, etwa über 20 μm, nicht mit ausreichender Qualität hinsichtlich Auflösung, Kantensteilheit und Haftfestigkeit hergestellt werden.

Die Titankomplex-Fotoinitiatoren von EP-OS 119162 enthalten bevorzugt gebundenes Fluor, das aus Stabilitäts-und Korrosionsgründen ebenfalls nachteilig ist. Weiterhin sprechen diese Initiatoren auch auf längerwellige Strahlung über ca. 450 nm an, so daß die übliche gelbe Sicherheitsbeleuchtung während der Verarbeitung nicht mehr ausreicht.

Ein gravierender Nachteil aller Fotoresistsysteme vom Polyimid-Typ, die strahlungsvernetzbare ungesättigte Komponenten enthalten, ist, daß sich während der thermischen Imidisierung zur Erzeugung einer hochwärmebeständigen Polyimid-Schicht bzw. -Reliefstruktur ein nicht unerheblicher Anteil des in der Fotoresistschicht enthaltenden Materials verflüchtigt. Dabei handelt es sich im wesentlichen um die strahlungsvernetzten Anteile, die aus dem Polyamid-Präpolymer und/oder den ungesättigten zusätzlichen Komponenten stammen. Lediglich der Polyamidsäure-Grundkörper unterliegt naturgemäß der thermischen Imidisierung der dann den wesentlichen Teil der getemperten Polymerschicht bildet. Dies hat zur Folge, daß während der Temperung ein nicht unerheblicher und vielfach problematischer Schichtdickenverlust eintritt. Es kann ebenfalls zu flächenmäßiger Kontraktion der Resistschicht kommen, was zu Spannungen bis hin zur Schichtablösung oder, im Falle von dünnen und nicht ausreichend biegefesten Substraten, zur Verbiegung des Substrates führt.

Es bestand die Aufgabe, Negativ-Fotoresists vom Polyimid-Typ mit diesbezüglich verbesserten Eigenschaften zu entwickeln. Insbesondere sollten hierbei neue Fotoinitiatoren für derartige Fotoresists gefunden werden, die die Nachteile der bekannten Fotoinitiatoren nicht aufweisen.

Überraschend wurde nun gefunden, daß 1,2-Disulfon-Verbindungen der Formel I

$R^1-SO_2-SO_2-R^2$     I

worin $R^1$ und $R^2$ gleich oder verschieden sein können und Alkyl, Cycloalkyl, Aryl, Aralkyl oder Heteroaryl mit bis zu 12 C-Atomen, gegebenenfalls ein- oder mehrfach substituiert mit Halogen, Cyano, Nitro, Alkyl, Alkoxy, Alkylthio, Mono- oder Bisalkylamino, Alkanoyl, Acyloxy, Acylamido, Alkoxycarbonyl, Alkylaminocarbonyl, Alkylsulfoxy, Alkylsulfonyl, Aryloxy, Arylthio, Arylsulfoxy, Arylsulfonyl mit jeweils bis zu 6 C-Atomen bedeuten, als Fotoinitiatoren für Negativ-Fotoresist vom Polyimid vorzüglich geeignet sind. 1,2-Disulfone verleihen derartigen Fotoresists eine hohe Empfindlichkeit im Bereich von ca. 200-450 nm ohne dabei im Bereich der gelben Sicherheitsbeleuchtung zu sensibilisieren; sie sind weiterhin in diesen Systemen stabil, sie sind nicht explosionsgefährlich und enthalten darüber hinaus normalerweise keine mit der Mikroelektronik nicht kompatiblen Elemente. Als besonders unerwartet wurde darüber hinaus gefunden, daß bei einem Einsatz von Verbindungen der Formel I als Fotoinitiatoren in Negativ-Fotoresists vom Polyimid-Typ photopolymerisierbare ungesättigte Komponenten in diesen Systemen entbehrlich sind.

Gegenstand der Erfindung sind daher Negativ-Fotoresists vom Polyimid-Typ, enthaltend in einem organischen Lösungsmittel im wesentlichen mindestens je

a) ein in hochwärmebeständiges Polyimidpolymer überführbares Polyamidsäure- oder Polyamidsäurederivatpräpolymer,

b) einen Fotoinitiator, sowie gegebenenfalls weitere übliche Zusatzstoffe, wobei diese als Fotoinitiator eine Verbindung der Formel I

$R^1-SO_2-SO_2-R^2$     I

worin $R^1$ und $R^2$ gleich oder verschieden sein können und Alkyl, Cycloalkyl, Aryl, Aralkyl oder Heteroaryl mit bis zu 12 C-Atomen, gegebenenfalls ein- oder mehrfach substituiert mit Halogen, Cyano, Nitro, Alkyl, Alkoxy, Alkylthio, Mono- oder Bisalkylamino, Alkanoyl, Acyloxy, Acylamido, Alkoxycarbonyl, Alkylaminocarbonyl, Alkylsulfoxy, Alkylsulfonyl, Aryloxy, Arylthio, Arylsulfoxy, Arylsulfonyl mit jeweils bis zu 6 C-Atomen bedeuten, enthalten.

Gegenstand der Erfindung sind insbesondere Negativ-Fotoresists vom Polyimid-Typ mit 1,2-Disulfonverbindungen der Formel I als Fotoinitiatoren, die keine photopolymerisierbaren ungesättigten Komponenten enthalten.

Gegenstand der Erfindung ist weiterhin die Verwendung von Verbindungen der Formel I als Fotoinitiatoren in Negativ-Fotoresists auf Basis von in hochwärmebeständige Polyimid-Polymere überführbaren Polyamidsäure- oder Polyamidsäurederivat-Präpolymeren.

Gegenstand der Erfindung ist auch ein Verfahren zur Herstellung von Reliefstrukturen aus hochwärmebeständigen Polyimdipolymeren durch Beschichten eines Substrates mit einem Negativ-Fotoresist vom Polyimid-Typ, Trocknen der Schicht, bildmäßiges Belichten der Schicht mit UV-Strahlung einer Wellenlänge zwischen 200 und 450 nm, Entwicklung durch Ablösen der nicht bestrahlten Schichtteile und Tempern der erhaltenen Reliefstrukturen, wobei ein wie vorstehend charakterisierter Negativ-Fotoresist verwendet wird.

Die erfindungsgemäß in Negativ-Fotoresists vom Polyimid-Typ als Fotoinitiatoren einzusetzenden 1,2-Disulfonverbindungen der Formel I sind zum großen Teil an sich bekannt. Von einigen 1,2-Diaryldisulfonen ist zwar auch bekannt, daß sie strahlungsreaktiv sind. So ist beispielsweise aus Bull. Chem. Soc. Jap. 45, 2906 (1972) (CA 78: 15196c) bekannt, daß Diaryldisulfone photoreaktiv sind und unter Strahlungseinwirkung in Radikale zerfallen. Nach JP 58-83844 (CA 101: 63684a) werden solche Verbindungen als Radikalerzeuger in lichtempfindlichen Zusammensetzungen für photolithographische Zwecke eingesetzt. In den dort beschriebenen Systemen dienen sie jedoch lediglich zur Auslösung einer Farbreaktion um einen visuellen Kontrast zwischen bestrahlten und nicht bestrahlten Schichtbereichen zu erzeugen. Für die Fotostrukturierungen der Schicht müssen in jedem Fall weitere strahlungsreaktive Verbindungen vorhanden sein. Gemäß Makromol. Chem., Rapid Commun. 4, 539 (1983) (CA 99: 140979v) und JP 59-197422 (CA 102: 186029u) können Diaryldisulfone als Strahlungsvernetzer für Epoxy-funktionalisierte Acrylatpolymere verwendet werden. Diesem Stand der Technik konnte jedoch nicht entnommen werden, daß sich 1,2-Disulfone insbesondere von weitaus breiterer struktureller Vielfalt vorzüglich als Fotoinitiatoren für Negativ-Fotoresists vom Polyimid-Typ eignen, vor allem auch dann, wenn diese gar keine photovernetzbaren ungesättigten Komponenten enthalten.

In Formel I können die Substituenten $R^1$ und $R^2$ gleich oder verschieden sein und Alkyl, Cycloalkyl, Aryl, Aralkyl oder Heteroalkyl mit bis zu 12 C-Atomen, gegebenenfalls ein- oder mehrfach substituiert mit Halogen, Cyano, Nitro, Alkyl, Alkoxy, Alkylthio, Mono- oder Bisalkylamino, Alkanoyl, Alkanoyloxy, Alkanoylamido, Alkoxycarbonyl, Alkylaminocarbonyl, Alkylsulfoxy, Alkylsulfonyl, Aryloxy, Arylthio, Arylsulfoxy, Arylsulfonyl mit jeweils bis zu 6 C-Atomen bedeuten.

Bevorzugte Reste $R^1$ und $R^2$ sind beispielsweise Methyl, Ethyl, n- und i-Propyl, Cyclohexyl, Phenyl, Benzyl, Pyridyl, Naphthyl, Tolyl, Anisyl, 2,4,6-Trimethylphenyl, 4-Isopropylphenyl, Chlor-, Brom- und Nitrophenyl.

Die Verbindungen der Formel I können im Prinzip alle nach Verfahren hergestellt werden, wie sie für 1,2-Disulfone in der Literatur bereits beschrieben sind. Gemäß der deutschen Patentanmeldung P 38 04 316 hat sich als ein Syntheseverfahren der Wahl erwiesen, 1,2-Disulfonylhydrazine, die leicht durch Umsetzung von Hydrazin mit Sulfonsäurechloriden zugänglich sind, mit konzentrierter Salpetersäure als Oxidationsmittel zu den 1,2-Disulfonen der Formel I zu oxidieren. Dieser Syntheseweg ist sehr ein fach, erbringt gute Ausbeuten und ermöglicht den Zugang zu praktisch beliebigen Substituentenkombinationen von $R^1$ und $R^2$.

Bevorzugt werden als Fotoinitiatoren in den erfindungsgemäßen Negativ-Fotoresists vom Polyimid-Typ symmetrische und insbesondere unsymmetrische 1,2-Disulfon-Verbindungen der Formel I eingesetzt, bei denen $R^1$ und $R^2$ Phenyl, mit Methyl, Methoxy oder Isopropyl substituiertes Phenyl, oder $C_{1-3}$-Alkyl darstellen. Als Beispiele für solche Verbindungen sind besonders hervorzuheben 1,2-Diphenyldisulfon, 1-(4-Methylphenyl)-2-phenyldisulfon, 1-(4-Methoxyphenyl)-2-phenyldisulfon, 1-(4-Isopropylphenyl)-2-phenyldisulfon, 1-(4-Methylphenyl)-2-methyldisulfon, 1,2-Di-n-propyldisulfon, 1-(4-Methoxyphenyl)-2-n-propyldisulfon.

Die Verbindungen der Formel I können je nach Natur der Substituenten $R^1$ und $R^2$ in einem Wellenlängenbereich von etwa 200 bis 450 nm als Fotoinitiatoren eingesetzt werden. Verbindungen der Formel I, in denen die Substituenten $R^1$ und $R^2$ Phenyl oder niedrig substituiertes Phenyl darstellen, sind besonders effektiv vornehmlich im tiefen bis mittleren UV-Bereich, etwa zwischen 200 und 280 nm. Durch den Zusatz von in längerwelligen Bereichen absorbierenden Cosensibilisatoren bekannter Art, etwa aromatische Ketone wie Michler's Keton, kann, falls nötig, die Empfindlichkeit der erfindungsgemäßen Negativ-Fotoresists in den nahen UV-Bereich verschoben werden. Eine für die praktische Anwendung ausreichende Initiatorwirkung geht von den Verbindungen der Formel I aus, wenn sie in den erfindungsgemäßen Negativ-Fotoresists vom Polyimid-Typ in einem Anteil von 0,1 bis 20 Gew.%, vorzugweise 1 lis 10 Gew.%, bezogen auf den Gesamtfeststoffgehalt der Fotoresistlösung, enthalten sind.

In den erfindungsgemäßen Negativ-Fotoresists vom Polyimid-Typ ist die schichtbildende Komponente im wesentlichen ein in hochwärmbeständiges Polyimid- bzw. Polyimid-verwandtes Polymer überführbares Polyamidsäure- oder Polyamidsäurederivat-Präpolymer. Im Prinzip kommen hierfür alle derartigen bekannten Präpolymere in Frage, wie sie etwa in den eingangs zitierten Publikationen vielfältig beschrieben sind. Ganz allgemein handelt es sich hierbei um Polykondensations- oder Polyadditionsprodukte von tetrafunktionellen aromatischen Verbindungen, die zwei zu Polykondensations- bzw. Polyadditionsreaktionen befähigte funktionelle Gruppen und zwei zu diesen benachbarte Carboxyl-oder derivatisierte Carboxyl-Gruppen aufweisen, mit entsprechend umsetzbaren difunktionellen aromatischen Verbindungen wie aromatischen Diaminen, Diisocyanaten, Dicarbonsäuren oder Bis-carbonsäurechloriden. Überwiegend leiten sich die resultierenden Polyamid-Präpolymere von ein- oder zweikernigen Tetracarbonsäuren und ein- oder zweikernigen Diaminen ab. Die zugrundeliegenden Tetracarbonsäuren sind vorzugsweise Pyromellithsäure, 3,3',4,4'-Benzophenontetracarbonsäure; die zugrundeliegenden Diamine sind vorzugsweise 4,4'-Diaminodiphenylether, 4,4'-Diaminodiphenylmethan und 4,4'-Diaminodiphenylsulfon. Ganz besonders bevorzugt sind Präpolymere, denen Pyromellithsäure oder 3,3',4,4'-Benzophenontetracarbonsäure und 4,4'-Diaminodiphenylether zugrundeliegen. Diese Präpolymere sind in einfacher Weise, wie etwa in den eingangs zititerten Publikationen beschrieben, durch Umsetzung äquimolarer Mengen der Dianhydride der zugrundeliegenden Tetracarbonsäuren mit den entsprechenden Diaminen herstellbar. Werden die jeweiligen zwei Carbonsäurereste, die pro Tetracarbonsäureeinheit für die Polyamidbindung nicht benötigt werden, vorher oder im weiteren Verlauf nicht umgesetzt, so resultieren Polyamidsäurepräpolymere. Werden diese Carbonsäurereste zusätzlich einer Umsetzung unterzogen, beispiels weise zur Bildung entsprechender Salze, Carbonsäureester oder Carbonsäureamide, so resultieren die entsprechenden Polyamidsäurederivat-Präpolymere. Als Salze kommen in solchen Fällen vornehmlich die Alkalimetall- und Ammoniumsalze und insbesondere Salze mit tertiären aliphatischen oder gegebenenfalls auch ungesättigt substituierten Aminen in Frage, wie beispielsweise von Trimethylamin, Triethylamin oder 2-(N,N-Dimethylamino)ethylmethacrylat. Im Falle von Polyamidsäureestern handelt es sich vornehmlich um die Ester niederer aliphatischer Alkohole wie Methanol und Ethanol; es können auch die aus DE-PS 24 37 348 bekannten ungesättigten Ester von Glycolmonoallylether oder 2-Hydroxyethylmethacrylat sein. Mit aliphatischen Aminen, wie etwa Methylamin oder Ethylamin, oder ungesättigten Aminen, wie 2-Aminoethylmethacrylat lassen sich die freien Carbonsäurefunktionen der Polyamidsäure-Präpolymere zu den entsprechenden Säureamiden derivatisieren. Besonders bevorzugt als schichtbildende Komponenten für die erfindungsgemäßen Negativ-Fotoresists vom Polyimid-Typ sind die aus Pyromellithsäuredianhydrid bzw. 3,3',4,4'-Benzophenontetracarbonsäuredianhydrid und 4,4'-Diaminodiphenylether herstellbaren Polyamidsäuren, deren Methyl-, Ethyl- und Methacryloyloxyethylester sowie deren Salze mit 2-(N,N-Dimethylamino)ethylmethacrylat.

Die in den erfindungsgemäßen Negativ-Fotoresists vom Polyimid-Typ einzusetzenden Polyamidsäure- bzw. Polyamidsäurederivat-Präpolymere können in einem weiten Bereich variierende Molmassen aufweisen. Wesentliche Voraussetzung ist nur, daß sie in üblichen Lösungsmitteln ausreichend löslich sind und bei der

4

Beschichtung nach dem Abdunsten des Lösungsmittels eine trockene feste Schicht bilden. Vorzugsweise liegen die Molmassen im Bereich zwischen 5 000 und 100 000 insbesondere zwischen 10 000 und 30 000. In den erfindungsgemäßen Fotoresists liegt das Präpolymer üblicherweise in einem Anteil von 50-95 Gew.%, vorzugsweise 70-90 Gew.%, bezogen auf den Gesamtgehalt der Fotoresistlösung, vor.

Als Lösungsmittel zur Herstellung der Fotoresistlösung sind im Prinzip alle Lösungsmittel geeignet, in denen die festen Fotoresistbestandteile wie Präpolymer, Verbindung(en) der Formel I und gegebenenfalls weitere Zusatzstoffe ausreichend löslich sind und die mit diesen Bestandteilen nicht irreversibel reagieren. In Frage kommen hierfür beispielsweise aprotische polare Lösungsmittel wie Dimethylformamid, Dimethylacetamid, N-Methylpyrrolidon, Hexamethylphosphorsäuretriamid und Butyrolacton, aliphatische Ketone wie Methylethylketon, Cyclopentanon oder Cyclohexanon, aliphatische Ester wie Ethylacetat oder Butylacetat, Ether wie Dioxan oder Tetrahydrofuran, Mono- oder Bisether sowie Ether- oder Esterderivate von Glycolverbindungen wie Ethylenglycolmonomethylether, Ethylenglycoldimethylether, Ethoxyethylacetat oder Methoxypropylacetat, des weiteren Monooxocarbonsäureester wie Milchsäureethylester oder 2-Ethoxypropionsäureethylester. Vielfach werden auch Gemische aus den genannten Lösungsmitteln verwendet. Bevorzugt enthalten die erfindungsgemäßen Fotoresists N-Methylpyrrolidon und Cyclopentanon als Lösungsmittel. Das Lösungsmittel hat üblicherweise einen Anteil von 40-90 Gew.% an der gesamten Fotoresistlösung.

Negativ-Fotoresists vom Polyimid-Typ, die nur Präpolymere, insbesondere auch ohne photopolymerisierbare Gruppen, und 1,2-Disulfone der Formel I als Fotoinitiatoren enthalten, sind bereits voll funktionsfähig und für die praktische Anwendung einsetzbar. Zur Anpassung an die Erfordernisse des jeweiligen Einsatzzweckes können diese durch in dieser Technologie übliche Zusatzstoffe noch weiter modifiziert und beispielsweise hinsichtlich spektraler Empfindlichkeit, Eigenabsorption, Mindestbelichtungsenergie, der erzielbaren Bildauflösung und Kantenschärfe, den Beschichtungs- und Entwicklungseigenschaften optimiert werden.

Als modifizierende Zusätze können die erfindungsgemäßen Fotoresists Sensibilisatoren zur spektralen Sensibilisierung, wie sie vielfältig aus dem einschlägigen Stand der Technik bekannt sind, enthalten. Vorzugsweise enthalten sie Arylketon-Sensibilisatoren wie Benzophenon, 4,4'-Bis(dimethylamino)benzophenon (Michler's Keton) oder 4,4'-Bis(diethylamino)benzophenon.

Zur Steigerung der Empfindlichkeit können die erfindungsgemäßen Fotoresists vom Polyimid-Typ analog zu den bekannten Fotoresists dieses Typs zusätzlich auch photopolymerisierbare ungesättigte Komponenten enthalten. Es können dies mono-, di- oder polyfunktionelle Acryl- bzw. Allylverbindungen, insbesondere Acryl- und Allylester bzw. Acryl- und Allylether von aliphatischen, cycloaliphatischen oder auch aromatischen Polyhydroxyverbindungen, sowie Vinylverbindungen wie Vinylether-, Vinylthioether-oder Vinylsulfonverbindungen sein. Als Beispiele photopolymerisierbarer ungesättigter Verbindungen seien genannt Acrylverbindungen wie Trimethylolpropantriacrylat bzw. -trimethacrylat, ethoxyliertes Trimethylolpropantriacrylat, Pentaerythrittriarcylat, bzw. -trimethacrylat; Mono- und Diacrylate bzw. -methacrylate von Ethylenglycol oder Di-, Tri- und Tetraethylenglycol wie etwa Ethylenglycolmonoacrylat, Triethylenglycoldimethacrylat, Tetraethylenglycolmonoacrylat, Tetraethylenglycoldimethacrylat; Allylether wie Trimethylpropantriallylether und Pentaerythrittriallylether; Vinylverbindungen wie 2-Hydroxyethylvinylether und 2-Hydroxethylvinylsulfon.

An derartigen photopolymerisierbaren ungesättigten Komponenten können die erfindungsgemäßen Fotoresists 0-35 Gew.%, vorzugsweise 5-15 Gew.% bezogen auf den Gesamtfeststoffgehalt der Fotoresistlösung, enthalten.

Weiterhin können die erfindungsgemäßen Fotoresists noch Farbstoffe enthalten, mit denen einerseits ebenfalls die spektrale Empfindlichkeit gesteuert werden kann und die insbesondere zur Unterdrückung unerwünschter Streustrahlungseffekte dienen. Bevorzugt sind hierbei Leukofarbstoffe vom Typ der Triarylmethane wie sie aus dem einschlägigen Stand der Technik bekannt sind. Derartige Farbstoffe können in einem Anteil von 0,1-5 Gew.%, vorzugsweise 0,5-2,5 Gew.% bezogen auf den Gesamtfeststoffgehalt der Fotoresistlösung, vorhanden sein.

Zu den weiteren üblichen Zusatzstoffen, die gegebenenfalls auch in den erfindungsgemäßen Negativ-Fotoresists vom Polyimid-Typ enthalten sein können, gehören Haftvermittler, Verlaufmittel, Weichmacher, weitere filmbildende Harze, Tenside und Stabilisatoren. Zusätze dieser Kategorien sind dem Fachmann ausreichend bekannt und sind vielfältig in der einschlägigen Fachliteratur beschrieben. Der Anteil an solchen Zusätzen übersteigt zusammengenommen kaum 25 Gew.% bezogen auf den Gesamtfeststoffgehalt der Fotoresistlösung.

Die Formulierung der erfindungsgemäßen Fotoresists erfolgt in an sich bekannter Weise durch Mischen bzw. Lösen der Komponenten in dem Lösungsmittel bzw. Lösungsmittelgemisch. Nach Lösung der Bestandteile im Lösungsmittel wird die erhaltenen Fotoresistlösung je nach Anspruch an die Partikelfreiheit durch Membranfilter mit einer Porenweite von 0,1-1 μm filtriert. Üblicherweise wird der Gesamtfeststoffgehalt des Fotoresist auf die gewünschte Schichtdicke und Beschichtungsmethode abgestimmt.

Die Anwendung erfolgt nach an sich bekanntem Verfahren und mit den hierfür üblichen Prozeßgeräten durch Beschichten eines Substrates mit der Fotoresistlösung, Trocknen der Schicht bei erhöhter Temperatur, bildmäßiges Belichten der Schicht mit Strahlung aus einem Wellenlängenbereich in dem die Schicht empfindlich ist, Entwicklung durch Ablösen der nicht bestrahlten Schichtteile und Tempern der erhaltenen Reliefstrukturen.

Als Substrate fungieren überwiegend Halbleiterscheiben, wie z.B. Silizium-Wafer, die gegebenenfalls mit einer Schicht aus Siliziumdioxid, Siliziumnitrid oder Aluminium überzogen sind. Auch andere bei der Herstellung miniaturisierter Schaltungen übliche Materialien, wie Germanium, Galliumarsenid, Keramik mit gegebenenfalls Edelmetallbeschichtung kommen in Frage.

Die Beschichtung erfolgt üblicherweise durch Tauchen, Sprühen, Walzen oder Aufschleudern. Bei der letzteren, am häufigsten angewandten Beschichtungsmethode, ist die resultierende Schichtdicke abhängig von der Viskosität der Fotoresistlösung, dem Feststoffgehalt und der Aufschleudergeschwindigkeit. Für den jeweiligen Fotoresist werden sogenannte Schleuderkurven ermittelt, aus denen sich die Resistschichtdicken in Abhängigkeit von Viskosität und Schleuderdrehzahl ermitteln lassen. Die erfindungsgemäßen Fotoresists können vorteilhaft zur Erzeugung von Schichten und Reliefstrukturen mit Schichtdicken zwischen 0,1 und 500 μm eingesetzt werden. Dünne Schichten, etwa bei der Anwendung als temporäre Fotoresists oder als Isolationsschicht oder Dielektrikum, in Mehrlagenschaltungen liegen typisch zwischen 0,1 und 5 μm, insbesondere 1-2 μm. Dicke Schichten, etwa bei der Anwendung als Passivierschicht oder α-Strahlungsschutz bei Halbleiterspeicherelementen liegen typisch zwischen 10 und 200 μm, insbesondere 20-100 μm.

Nachdem der Fotoresist auf das Substrat aufgebracht worden ist, wird er normalerweise bei Temperaturen zwischen 50 und 120 °C vorgetrocknet. Dazu können Öfen oder Heizplatten verwendet werden. Die Trocknungszeit in Öfen liegt im Bereich von etwa 10-60 Minuten, kann aber bei dicken Schichten auch mehrere Stunden betragen. Auf Heizplatten liegt die Trocknungszeit normalerweise im Bereich von etwa 0,5-5 Minuten.

Anschließend wird die Fotoresistschicht der Strahlung ausgesetzt, welche die Reaktion der strahlungsreaktiven Bestandteile unter Vernetzung der Schicht verursacht. Üblicherweise wird aktinisches Licht verwendet, aber auch engeriereiche Strahlung wie Röntgen- oder Elektronenstrahlung kann verwendet werden. Die Bestrahlung oder Belichtung kann durch eine Maskenvorlage durchgeführt werden, es kann aber auch ein gebündelter Strahl der Strahlung über die Oberfläche der Fotoresistschicht geführt werden. Üblicherweise werden zur Bestrahlung UV-Lampen verwendet, die Strahlung einer Wellenlänge von 200-500 nm, vorzugsweise 300-400 nm, aussenden. Die Belichtung kann poly-oder monochromatisch erfolgen. Bevorzugt werden hierzu kommerziell erhältliche Belichtungsgeräte, wie z.B. Kontakt- und Abstandsbelichtungsgeräte, Scanning-Projektions-Belichtungsgeräte oder Wafer-Stepper eingesetzt.

Nach der Belichtung kann nun ein Bildmuster unter Freilegung von Teilen des Substrates entwickelt werden, indem die Schicht mit einer Entwicklerlösung behandelt wird, die die nicht bestrahlten Bereiche der Fotoresistschicht entfernt. Als Entwickler werden in der Regel die für die Herstellung der Fotoresistlösung üblichen Lösungsmittel, gegebenenfalls auch im Gemisch, verwendet. Vielfach werden auch Gemische aus einem Lösungsmittel und einem Nichtlösungsmittel als Entwickler eingesetzt. Als Nichtlösungsmittel gelten hierbei Alkohole wie Methanol, Ethanol und Isopropanol sowie Aromaten wie Toluol und Xylol. Typische Entwicklermischung sind beispielsweise 4-Butyrolacton/Toluol, Dimethylformamid/Ethanol, Methylethylketon/Methanol, Cyclopentanon/Isopropanol, jeweils im Verhältnis 2:1 bis 1:4. Besonders bevorzugte Entwickler für die erfindungsgemäßen Fotoresists sind Cyclopentanon und Cyclopentanon/Isopropanol. Die Entwicklungszeiten hängen von der Belichtungsenergie, Stärke des Entwicklers, Art des Entwickelns, der Vortrocknungstemperatur und der Entwicklertemperatur ab. Bei der Sprühentwicklung sind Entwicklungszeiten von 10-30 Sekunden, bei der Tauchentwicklung von etwa 1-2 Minuten typisch. Die Entwicklung wird üblicherweise durch Eintauchen oder Besprühen mit einem Nichtlösungsmittel gestoppt.

Mit den erfindungsgemäßen Negativ-Fotoresists vom Polyimid-Typ können Polymerbeschichtungen und kantenscharfe Reliefstrukturen mit Schichtdicken zwischen 0,1 und 500 μm erhalten werden, wobei Bildauflösungen, je nach Schichtdicke, bis herab zu etwa 1 μm möglich sind. Durch Temperung bei einer Temperatur zwischen etwa 200 und 400 °C wird das Polyamidsäure- bzw. Polyamidsäurederivat-Präpolymer, das den wesentlichen Teil der Fotoresistschicht bzw. -Reliefstruktur bildet, durch termische Imidisierung in Polyimid überführt. Der Schichtdickenverlust während der Temperung ist je nach Anteil an flüchtigen Komponenten mäßig bis gering. Im Falle von erfindungsgemäßen Fotoresists, die nur Polyamidsäure-Präpolymer und 1,2-Disulfon-Fotoinitiator enthalten, ist bei der Temperung praktisch kein Schichtdickenverlust zu verzeichnen. Die erfindungsgemäßen Negativ-Fotoresists vom Polyimid-Typ sind durch ihren Gehalt an 1,2-Disulfon-Fotoinitiatoren im Wellenlängenbereich zwischen 200 und 450 nm strukturierbar und bei gelber Sicherheitsbeleuchtung problemlos bearbeitbar. Sie sind über längere Zeit hinweg lagerstabil; aufgrund der Stabilität der 1,2-Disulfone ist eine Abnahme der Strahlungsempfindlichkeit auch bei längerer Lagerung nicht zu verzeichnen. Die eingesetzten 1,2-Disulfon-Fotoinitiatoren sind darüber hinaus in keiner Weise explosionsgefährlich und enthalten in der Regel keine mit Halbleitermaterialien nicht kompatible Elemente. Gerade in diesen Eigenschaften liegt der besondere Wert der erfindungsgemäßen Fotoresists für die praktische Anwendung.

Beispiele

A. Allgemeine Vorschrift zur Herstellung von 1,2-Disulfonen der Formel $R^1-SO_2-SO_2-R^2$ (I)

Zur entsprechenden 1,2-Disulfonylhydrazinverbindung wird unter Rühren und Eiskühlung konzentrierte Salpetersäure (Dichte 1,4) getropft. Die Reaktion setzt nach einigen Minuten unter Stickstoffentwicklung ein. Nach Abklingen der Reaktion wird noch etwa 1 Stunde bei 0 °C gerührt, der ausgefallene Niederschlag abgetrennt und zur Reinigung umkristallisiert.

B. Hergestellte Verbindungen

| Nr. | $R^1$ | $R^2$ | Umkristalli- lisiert aus | Schmelz- punkt (°C) |
|-----|-------|-------|--------------------------|---------------------|
| 1 | Phenyl | Phenyl | Ethanol | 192 |
| 2 | " | 4-Methylphenyl | Methanol | 177 |
| 3 | " | 4-Methoxyphenyl | Aceton | 153 |
| 4 | " | 2-Naphthyl | Methyl-t-Butyl- ether | 182 |

| | | | | |
|---|---|---|---|---|
| 5 | " | Benzyl | Methyl-t-Butyl-ether/Aceton | 186 |
| 6* | " | 2-Nitro-3,5-dimethoxyphenyl | Aceton | 186 |
| 7 | " | 2,4,6-Trimethyl-phenyl | Toluol | 154 |
| 8 | " | 4-i-Propylphenyl | Eisessig | 92 |
| 9 | " | 4-Chlorphenyl | Toluol | 181 |
| 10 | " | 4-Bromphenyl | Aceton | 198 |
| 11 | 4-Methylphenyl | 4-Methylphenyl | Aceton/Ether | 222 |
| 12 | " | 4-Chorphenyl | Toluol | 206 |
| 13 | " | Benzyl | Methanol | 126 |
| 14 | 4-Methylphenyl | 2-Naphthyl | Methyl-t-Butyl-ether/Dichlor-methan | 186 |
| 15 | " | 4-Methoxyphenyl | Aceton | 173 |
| 16* | " | 2-Nitro-3,5-dimethoxyphenyl | Aceton | 182 |
| 17 | " | Methyl | Methyl-t-Butyl-ether | 109 |
| 18 | " | 1-Naphthyl | Aceton | 201 |
| 19 | 1-Naphthyl | 1-Naphthyl | Aceton/DMF | 183 (Zer-setzung) |
| 20 | 2-Naphthyl | 2-Naphthyl | THF | 226 (Zer-setzung) |
| 21 | 4-Methoxy-phenyl | 4-Methoxyphenyl | Aceton | 194 (Zer-setzung) |
| 22 | 4-Nitrophenyl | 4-Nitrophenyl | THF | 224 (Zer-setzung) |
| 23 | 2-Methylphenyl | 2-Methylphenyl | Toluol | 160 |
| 24 | Benzyl | Benzyl | Eisessig | 183 (Zer-setzung) |
| 25 | Benzyl | n-Propyl | Dichlormethan/n-Pentan | 100 |
| 26 | n-Propyl | n-Propyl | (Wasser)** | 53 |
| 27 | n-Propyl | 4-Nitrophenyl | Methyl-t-Butyl-ether | 111 |

| 28 | n-Propyl | 4-Methoxyphenyl | Petrolether | 83 |
|----|----------|-----------------|-------------|-----|
| 29 | Phenyl | n-Propyl | Methyl-t-Butyl-ether | 138 |
| 30 | " | 4-t-Butylphenyl | (Wasser)** | 128 |
| 31 | 4-Methyl-phenyl | n-Propyl | (Wasser)** | 86 |
| 32 | 4-i-Propyl-phenyl | Methyl | - | (Öl) |
| 33 | 4-t-Butyl-phenyl | n-Propyl | Ether/Petrol-ether | 110 |
| 34 | 1-Naphthyl | Methyl | Toluol | 157 |
| 35 | 1-Naphthyl | n-Propyl | (Wasser)** | 116 |
| 36 | 2-Naphthyl | Methyl | (Wasser)** | 146 |
| 37 | 2-Naphthyl | n-Propyl | Ether/Petrolether | 67 |
| 38 | 4-Acetylamido-phenyl | n-Propyl | Eisessig | 189 |
| 39 | " | Phenyl | " | 208 |
| 40 | " | 4-Methylphenyl | " | 201 |
| 41 | " | 4-Methoxyphenyl | " | 204 |
| 42 | " | 4-Nitrophenyl | " | 198 (Zer-setzung) |
| 43 | 4-Phthalimido-phenyl | n-Propyl | " | 196 |
| 44 | " | Phenyl | Dichlormethan/Cyclohexan | 210 |
| 45 | " | 4-Methylphenyl | Eisessig | 214 |
| 46 | " | 4-Methoxyphenyl | " | 162 |
| 47 | 4-(1,2-Di-methylmalein-imido)phenyl | n-Propyl | Methyl-t-butylether | 143 |
| 48 | " | Phenyl | Dichlormethan | 222 |
| 49 | " | 4-Methylphenyl | Dichlormethan/Petrolether | 235 |
| 50 | " | 4-Methoxyphenyl | Eisessig | 162 |
| 51 | 4-Nitrophenyl | n-Propyl | Ether | 104 |

\*   Die Einführung der $NO_2$-Gruppe erfolgte hier während der Salpetersäure-Oxidation

\*\*   Kristallisiert bereits bei Zugabe von Wasser in aus-reichender Reinheit aus

C. Herstellung und Anwendung von Fotoresists

In den nachfolgenden Beispielen wurden, sofern dort nicht anders angegeben, die Fotoresistlösungen durch Mischen der angegebenen Komponenten und anschließende Feinfiltration hergestellt.

Die Fotoresist-Formulierungen wurden auf oberflächlich oxidierte Silizium-Scheiben von 4″ Durchmesser bei einer Drehzahl von etwa 5000 min⁻¹ aufgeschleudert und im Umluftofen bei 65 °C bzw. auf der Heizplatte bei 100 °C getrocknet.

Die Belichtung erfolgte polychromatisch (Gerät: Süss MJB 55; Hg-Höchstdrucklampe) durch eine Auflösungstestmaske mit Strukturen (Gräben und Stege) zwischen 2 und 100 μm im Vakuumkontakt mit zusäztlicher Stickstoffspülung, wobei die Belichtungsenergien bei 365 nm mit einer Meßsonde registriert wurden.

Entwickelt wurde im Sprühverfahren mit einem Gemisch aus gleichen Teilen Cyclopentanon und Isopropanol und Stoppen mit Isopropanol.

Beispiel 1

Zusammensetzung:

| | |
|---|---|
| Polyamidsäure-Lösung PI 2555 (Fa. Dupont) (Polykondensat aus Benzophenontetracarbonsäuredianhydrid und 4,4′-Diaminodiphenylether; 15%ige Lösung) | 10,0 g |
| 1-(4′-Isopropylphenyl)-2-phenyldisulfon (Verbindung Nr. 8) | 0,5 g |
| 4,4′-Bis(diethylamino)benzophenon | 0,25 g |
| N-Methylpyrrolidon | 2,0 g |

Bei einer Belichtungsenergie von 2700 mJ/cm² und einer resultierenden Schichtdicke von 1,1 μm waren alle Maskenstrukturen bildgetreu und kantenscharf wiedergegeben.

Beispiel 2 (Vergleichsversuch)

Mit der gleichen Formulierung, jedoch ohne 1,2-Disulfon-Fotoinitiator war unter gleichen Bedingungen keine Strukturierung möglich.

Beispiel 3

Zusammensetzung:

| | |
|---|---|
| Polyamidester-Präpoly-mer (Polykondensat aus Pyromellithsäuredian-hydrid, 4,4'-Diaminodiphenyl-ether und 2-Hydroxyethylmeth-acrylat gemäß DE-PS 24 37 348) | 35,0 g |
| Tetraethylenglycoldiacrylat | 7,0 g |
| 1,2-Diphenyldisulfon (Verbindung Nr. 1) | 2,0 g |
| 4,4'-Bis(diethylamino)benzophenon | 1,0 g |
| N-Methylpyrrolidon | 27,0 g |
| Cyclopentanon | 27,0 g |

Bei einer Belichtungsenergie von 65 mJ/cm$^2$ und einer Schichtdicke von 4,5 µm sind alle Maskenstrukturen bis herab zu einer Größe von 4 µm bildgetreu und kantenscharf wiedergegeben.

Nach Temperung (30 Minuten Aufheizen auf 250 °C/30 Minuten 250 °C/30 Minuten Aufheizen auf 400 °C) haben die in Polyimid umgewandelten Reliefstrukturen eine Schichtdicke von 2,2 µm ohne Verlust an Auflösung und Kantenschärfe.

Beispiele 4-16

Es wird wie in Beispiel 3 verfahren mit entsprechenden Zusammensetzungen, die aber andere 1,2-Disulfon-Fotoinitiatoren enthalten.

Bei den angegebenen Belichtungsenergien wurden Strukturen, deren Dimension gleich oder größer als die jeweilige Schichtdicke ist, bildgetreu und kantenscharf wiedergegeben.

| 1,2-Disulfon Verbindungs-Nr. | Schichtdicke (µm) | Belichtungs-energie (mJ/cm$^2$) |
|---|---|---|
| 2 | 4,1 | 82 |
| 3 | 3,6 | 90 |
| 4 | 5,4 | 135 |
| 5 | 5,6 | 224 |
| 7 | 4,7 | 94 |
| 9 | 4,9 | 98 |
| 11 | 4,6 | 138 |
| 15 | 4,8 | 120 |
| 17 | 5,1 | 117 |
| 23 | 4,6 | 92 |
| 28 | 5,2 | 208 |
| 36 | 4,8 | 96 |
| 41 | 4,7 | 140 |

Beispiel 17

Zusammensetzung:

| Polyamidester-Präpolymer (wie in Beispiel 3) | 41,0 g |
| Tetraethylenglycoldiacrylat | 8,0 g |
| 1,2-Diphenyldisulfon (Verbindung Nr. 1) | 2,0 g |
| Michler's Keton | 1,0 g |
| N-Methylpyrrolidon | 47,0 g |

Zur Herstellung einer dicken Schicht wurde nur bei einer Drehzahl von 1000 min$^{-1}$ aufgeschleudert und 3,5 Stunden bei 65 °C im Ofen getrocknet.

Bei einer Belichtungsenergie von 750 mJ/cm$^2$ und einer Schichtdicke von 30 μm sind Maskenstrukturen bis 20 μm bildgetreu und kantenscharf wiedergegeben.

Nach der Temperung (1,5 Stunden Aufheizen auf 400 °C/1 Stunde 400 °C) haben die in Polyimid umgewandelten Strukturen eine Schichtdicke von 18 μm ohne Verlust an Auflösung und Kantenschärfe.

## Beispiel 18

Zusammensetzung:

| Polyamidsäurelösung PI 2555 (wie in Beispiel 1) | 10,0 g |
| 2-(N,N-Dimethylamino)ethylmethacrylat | 1,0 g |
| Michler's Keton | 0,05 g |
| 1-(4-Methylphenyl)-2-phenyldisulfon | 0,03 g |
| N-Methylpyrrolidon | |

Trocknung: 30 Minuten bei 65 °C im Ofen. Entwicklung: 2 Minuten Tauchentwicklung in N-Methylpyrrolidon/Methanol 3:1.

Bei einer Belichtungsenergie von 105 mJ/cm$^2$ und einer Schichtdicke von 3,5 μm waren Strukturen bis 7 μm kantenscharf aufgelöst.

## Beispiel 19

Zusammensetzung:

Wie in Beispiel 3, jedoch als Präpolymer ein Polykondensat aus 3,3′,4,4′-Benzophenontetracarbonsäure, 4,4′-Diaminodiphenylether und 2-Hydroxyethylmethacrylat.

Bei einer Belichtungsenergie von 90 mJ/cm$^2$ und einer Schichtdicke von 6,1 μm sind Strukturen bis 4 μm bildgetreu und kantenscharf wiedergegeben.

## Patentansprüche

1. Negativ-Fotoresists vom Polyimid-Typ, enthaltend in einem organischen Lösungsmittel im wesentlichen mindestens je

a) ein in hochwärmebeständiges Polyimid-Polymer überführbares Polyamidsäure- oder Polyamidsäurederivat-Präpolymer

b) einen Fotoinitiator sowie gegebenenfalls weitere übliche Zusatzstoffe, dadurch gekennzeichnet, daß diese als Fotoinitiator eine Verbindung der Formel I

$R^1$-SO$_2$SO$_2$-$R^2$    I

worin $R^1$ und $R^2$ gleich oder verschieden sein können und Alkyl, Cycloalkyl, Aryl, Aralkyl oder Heteroaryl mit bis zu 12 C-Atomen, gegebenenfalls ein- oder mehrfach substituiert mit Halogen, Cyano, Nitro, Alkyl, Alkoxy, Alkylthio, Mono- oder Bisalkylamino, Alkanoyl, Acyloxy, Acylamido, Alkoxycarbonyl, Alkylaminocarbonyl, Alkylsulfoxyl, Alkylsulfonyl, Aryloxy, Arylthio, Arylsulfoxyl, Arylsulfonyl mit jeweils bis zu 6 C-Atomen bedeuten, enthalten.

2. Negativ-Fotoresists nach Anspruch 1, dadurch gekennzeichnet, daß diese keine photopolymerisierbare ungesättigte Komponenten enthalten.

3. Negativ-Fotoresists nach Anspruch 1 oder 2, dadurch gekennzeichnet, daß diese 0,1 bis 20 Gew.%, vorzugsweise 1 bis 10 Gew.%, an Verbindung(en) der Formel I enthalten.

3. Verwendung von Verbindungen der Formel I als Fotoinitiatoren in Negativ-Fotoresists auf Basis von in hochwärmebeständige Polyimid-Polymere überführbaren Polyamidsäure- oder Polyamidsäurederivat-Präpolymeren.

5. Verfahren zur Herstellung von Reliefstrukturen aus hochwärmebeständigen Polyimid-Poylmeren durch Beschichten eines Substrates mit einem Negativ-Fotoresist vom Polyimid-Typ, Trocknen der Schicht, bildmäßiges Belichten der Schicht mit UV-Strahlung einer Wellenlänge zwischen 200 und 450 nm, Entwicklung durch Ablösen der nicht bestrahlten Schichteile und Tempern der erhaltenen Reliefstrukturen, dadurch gekennzeichent, daß ein Negativ-Fotoresist nach einem der Ansprüche 1 bis 3 verwendet wird.